# EUROPÄISCHE PATENTSCHRIFT

(11) **EP 0 221 258 B1**
(45) Veröffentlichungstag und Bekanntmachung des Hinweises auf die Patenterteilung: **03.11.1993**
(21) Anmeldenummer: 86110871.0
(22) Anmeldetag: 06.08.1986
(51) Int. Cl.: H01S 3/19, H01S 3/23

(54) **Vielfachlaseranordnung**
Laser array device
Réseau de lasers

(30) Priorität: 30.09.1985 DE 3534912
(43) Veröffentlichungstag der Anmeldung: 13.05.1987
(73) Patentinhaber: SIEMENS AKTIENGESELLSCHAFT, 80333 München (DE)
(72) Erfinder: Luft, Johann, Dipl.-Phys., D-8000 München 90 (DE)

(56) Entgegenhaltungen:
- EP-A- 0 010 949
- EP-A- 0 045 862
- EP-A- 0 064 339
- EP-A- 0 156 014
- US-A- 3 531 735
- US-A- 3 701 044
- ELECTRONICS LETTERS, Band 21, Nr. 14, 4. Juli 1985, Seiten 603-605, Hitchin Harts, GB; D.F. WELCH et al.: "High-power (575 mW) single-lobed emission from a phased-array laser"
- APPLIED PHYSICS LETTERS, Band 45, Nr. 12, 15. Dezember 1984, Seiten 1257-1259, American Institute of Physics, New York, US; E. KAPON et al.: "Inverted-V chirped phased arrays of gain-guided GaAs/GaAlAs diode lasers"

## Beschreibung

Die Erfindung betrifft eine Vielfachlaseranordnung mit phasengekoppelten Laserdioden nach dem Oberbegriff des Anspruchs 1.

Für viele Anwendungen sind phasengekoppelte Laserdiodenarrays mit cw-Ausgangsleistungen im Watt-Bereich wünschenswert. Dazu sind Laser-Arrays mit vielen verkoppelten Einzelstreifen erforderlich.

Mit einer Vielfachlaseranordnung kann beispielsweise auch eine etwa fünf bis zehnfach höhere Strahlungsleistung in eine Monomodefaser eingekoppelt werden als dies mit Einzellasern möglich ist. Zur Einkopplung der Strahlungsleistung beispielsweise in eine Monomodefaser soll eine lateral verkoppelte Laseranordnung eine geeignete Abstrahlcharakteristik im Grundmodus mit einer einzigen Strahlungskeule besitzen. Laseranordnungen mit metallbeschichteter Stegwellenleiterstruktur (MCRW-Laser) erlauben die laterale Verkopplung derartiger Laser.

Phasengekoppelte Laserdiodenarrays schwingen mit zunehmender Anzahl von lateral verkoppelten Einzelstreifen bzw. bei Vergrößerung des Verhältnisses von Laserarray-Breite zu Laser-Resonatorlänge über den Wert 0,5 hinaus (bei asymmetrischer Beschichtung der Laserspiegel mit λ/4- und λ/2-Schichten zur einseitigen Erhöhung des differentiellen Wirkungsgrades) bevorzugt in verlustarmen, internen Schwingungsmoden, wodurch die Auskopplung der Laserstrahlung aus der Vielfachlaseranordnung (Laser-Array) weitgehend verhindert wird.

Dieser Effekt der weitgehenden Verhinderung der Auskopplung der Laserstrahlung begrenzte bisher die Größe und damit auch die maximale Ausgangsleistung von phasengekoppelten Laser-Arrays.

Aufbau und Wirkung einer Vielfachlaseranordnung (Laser-Array) ist aus Electronics/July 22, 1985, Seite 25, bekannt. Dabei ist eine Vielfachlaseranordnung mit vierzig Einzelstreifen beschrieben, von denen jeder Einzelstreifen 400 µm lang und 3 µm breit ist. Dabei ist auf einem Galliumarsenid-Substrat eine Gallium-Aluminium-Arsenid-Vielfachschicht aufgebracht. Die gesamte Laservielfachanordnung ist 0,4 bis 0,5 mm breit und 100 µm dick. Der Abstand von Einzelstreifenmitte zu Einzelstreifenmitte beträgt typisch 10 µm. Diese Vielfachlaseranordnung emittiert Strahlungsleistung in zwei Strahlungskeulen, die gegenseitig in einem Winkelbereich von 7^{.} angeordnet sind. Jede Strahlungskeule ist weniger als 2^{.} weit. Diese scharfe Bündelung der Strahlungsleistung ergibt sich aus dem phasengekoppelten Betrieb der Vielfachlaseranordnung. Die Vielfachlaseranordnung kann in Doppelheterostruktur oder in MQW (Multiple-Quantum-Well)-Struktur oder auch in einer anderen Struktur erzeugt werden. Die Schichten auf dem Substrat können in metallorganischer Gasphasenepitaxie (MOVPE) oder in Flüssigphasen-Epitaxie oder in anderer Technik erzeugt werden.

Bei den bisher bekannten Vielfachlaseranordnungen wird bisher eine teilweise Unterdrückung der internen Schwingungsmoden dadurch ermöglicht, daß als seitliche Laser-Array-Begrenzung V-förmig geätzte Gräben erzeugt werden oder daß durch Sägen oder auf andere Art erzeugte mechanische Beschädigungen der seitlichen Chip-Flächen zur Herabsetzung der Ringmodenrückkopplung vorgenommen wurden.

Jedoch zeigen Laser-Arrays mit λ/4-Beschichtung (Antireflexionsschicht auf einer Laserspiegelseite zur Erhöhung des differentiellen Wirkungsgrades) bereits bei einem Verhältnis von Laser-Array-Breite zu Laserresonaton-Länge von 0,45 praktisch keine Strahlungsauskopplung mehr, auch wenn die Seitenkanten des Laser-Array-Chips mittels V-Ätzung abgeschrägt sind.

Der vorliegenden Erfindung liegt die Aufgabe zugrunde, eine Vielfachlaseranordnung der eingangs genannten Art anzugeben, bei der die Auskopplung der Laserstrahlung verbessert ist.

Diese Aufgabe wird durch eine Vielfachlaseranordnung nach dem Anspruch 1 gelöst.

Die seitlichen Begrenzungen des Laserarray-Chips können auf mannigfaltige Art und Weise durch chemische, mechanische oder sonstige Einwirkung auf dem Laserarray-Chip erzeugt worden sein. Wichtig für die Erfindung ist, daß durch das Aufbringen von zusätzlichem, absorbierendem Material an wenigstens einer seitlichen Begrenzung der Vielfachlaseranordnung oder durch Aufbringen von Kunststoffmaterial an wenigstens einer seitlichen Begrenzung der Vielfachlaseranordnung die Unterdrückung von unerwünschten Quer- oder Ringmoden durch Auskopplung dieser Moden dadurch verbessert wird, daß diese unerwünschten Moden mit größerer Wahrscheinlichkeit aus der Laservielfachanordnung an wenigstens einer seitlichen Begrenzung der Laservielfachordnung ausgekoppelt werden als daß sie wieder in die Vielfachlaseranordnung zurückgekoppelt werden.

Weitere Vorteile und Ausgestaltungen der Erfindung sind in den Unteransprüchen, der Zeichnung und der Beschreibung dargestellt.
- Fig. 1: erläutert das Prinzip der Erfindung an einer Vielfachlaseranordnung.
- Fig. 2: verdeutlicht die Wirkung der Erfindung.

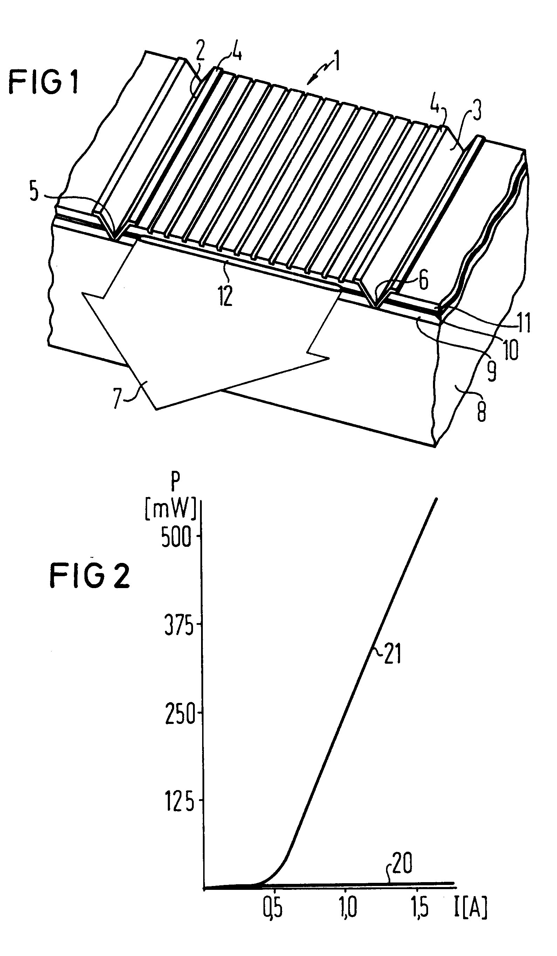

Fig. 1 zeigt eine Vielfachlaseranordnung 1. In den durch Ätzen bzw. durch Sägen erzeugten V-förmigen Gräben, die die seitlichen Begrenzungen 2, 3 des Laserarrays 1 bilden, wird ein die Stralung der unerwünschten Quer- oder Ringmoden absorbierendes Material 4 aufgebracht. Zur besseren Einkopplung dieser unerwünschten Strahlung in das absorbierende Material 4 ist es von Vorteil, wenn der Brechungsindex dieses absorbierenden Materials 4 demjenigen Brechungsindex angepaßt ist, den das Laserarray-Material an den seitlichen Begrenzungen des Laserarrays 1 aufweist.

Im Falle von Laserarrays mit einem Basismaterial aus Galliumarsenid eignen sich für das absorbierende Material 4 z.B. aufgesputterte oder aufgedampfte Schichten aus Silicium und/oder Germanium. Im Fall von Laserdioden-Arrays aus Indiumgalliumarsenidphosphid bzw. Indiumgalliumaluminiumarsenid auf einem Basismaterial aus Indiumphosphid kann die absorbierende Schicht 4 z.B. aus Indiumarsenid oder aus einer anderen Halbleiter-Schicht mit einem Energiebandabstand, der kleiner ist als derjenige Energiebandabstand, der das Material des Laserarrays 1 an der seitlichen Begrenzung aufweist, bestehen. Grundsätzlich kann jedes Material als absorbierendes Material 4 verwendet werden, das eine Auskopplung und Absorption von unerwünschten Moden aus dem Laserarray 1 ermöglicht.

Eine weitere möglichkeit anstelle der Beschichtung mit absorptiven Materialien 4 bietet sich durch Aufbringen von Kunstsoffmaterial an wenigstens einer seitlichen Begrenzung des Laserarrays 1. Ein geätzter seitlicher V-Graben 5, 6 kann mit Kunststoffmaterial ausgefüllt werden. Je nach Brechungsindex des verwendeten Kunststoffmaterials wird ein Teil der Ringmodenstrahlung aus dem Laserarraykristall ausgekoppelt und im wesentlichen nicht wieder zurück in den Laserarraykristall reflektiert, so daß dadurch die eigentliche, gewünschte Schwingungsmode des Laserarrays 1 begünstigt wird.

Das Laserarray 1 von Fig. 1 besitzt 12 Einzelstreifen. Das Laserarray 1 besteht aus einem Substrat 8 mit Schichtfolge 9, 10, 11. Das Laserarray 1 besitzt einen laseraktiven Bereich 12, aus dem die Laserstrahlung 7 emittiert wird.

Die jeweilige Lage der einzelnen Laserdiodenstreifen im Halbleiterkörper des Laserarrays 1 ist durch verschiedenartige Maßnahmen bestimmbar, so z.B. durch parallel verlaufende Oxidstreifen (Oxidstreifenlaser), durch parallel verlaufende Wellenführungsstreifen, durch parallel verlaufende hochohmige Streifenzonen und dergleichen.

Zwischen benachbarten laserkativen Bereichen in einem Halbleiterkörper kann optische Kopplung auftreten, mit dem Ergebnis, daß eine Korrelation zwischen dem in derartigen laseraktiven Zonen erzeugten Laserstrahlungen auftritt. Dies beruht auf einem Überlappen der Ausläufer der jeweiligen Wirkungsbereiche der betreffenden laseraktiven Zonen, und zwar auch über Bereiche des Halbleiterkörpers des Laserarrays 1 hinweg, in denen die Bedingungen für das Auftreten stimmulierter Emission bzw. das Vorhandensein einer Inversion, d.h. einer Umkehrung der natürlichen Besetzungsdichte von Energieniveaus, aus verschiedenen Gründen nicht gegeben ist, z.B. weil dort der Schwellenstromwert für die stimmulierte Emmission nicht erreicht ist.

Das an den seitlichen Begrenzungen des Laserarrays 1 aufgebrachte absorbierende Material 4 bzw. Kunststoffmaterial muß nicht die gesamten seitlichen Begrenzungen des Laserarrays 1 bedecken. Ein vorteilhafter Effekt wird bereits dann erzielt, wenn auch nur Teile dieser seitlichen Begrenzungen des Laserarrays 1 mit absorbierendem Material 4 bzw. mit Kunststoffmaterial bedeckt sind. Die Bedeckung der seitlichen Begrenzungen des Laserarrays 1 kann auch aus einer Mischung von Kunststoffmaterial und absorbierendem Material bestehen.

Fig. 2 verdeutlicht die Wirkung der Erfindung. Fig. 2 zeigt die Strahlungs (P)-Strom (I)-Kennlinie eines Galliumaluminiumarsenid (GaAIAs)-12-Streifen-Laserarrays 1 mit V-Nut-Ätzung zur seitlichen Begrenzung des Laserarray-Chips). Die Laserspiegel des 12-Streifen- Laserarrays sind asymmetrisch mit λ/4- und λ/2-Schichten beschichtet. Die Resonatorlänge des 12-Streifen-Laserarrays 1 beträgt 150 µm und die Laserarraybreite beträgt ca. 120 µm. Das 12-Streifenlaserarray ohne Beschichtung in der V-Nut zeigt keine Strahlungsauskopplung (Kennlinie 20), während das 12-Streifen-Laserarray mit einer aufgesputterten Germanium/Silicium-Schicht in der V-Nut mit einem differentiellen Wirkungsgrad von 0,5 W/A lasert (Kennlinie 21). Die 12-Streifen-Laserarrays besitzen dabei jeweils 12 phasengekoppelte Einzelstreifen. Die Kennlinien 20, 21 wurden mit einer Pulsmessung mit 1 µs Pulsdauer und 10 kH Pulsfrequenz erzielt.

## Patentansprüche

1. Vielfachlaseranordnung (1) mit phasengekoppelten Laserdioden innerhalb eines laseraktiven Bereichs (12), der seitliche Begrenzungen (2, 3) aufweist, **gekennzeichnet** durch V-förmige Gräben als seitliche Begrenzungen und entweder durch ein unerwünschte Quer- oder Ringmoden der Laserstrahlung absorbierendes Material (4) an den seitlichen Begrenzungen (2, 3) oder durch aufgebrachtes Kunststoff material an den seitlichen Begrenzungen (2, 3), das die unerwünschten Quer- oder Ringmoden der Laserstrahlung auskoppelt.

2. Vielfachlaseranordnung nach Anspruch 1, **dadurch gekennzeichnet**, daß der Brechungsindex des absorbierenden Materials (4) zur besseren Einkopplung der unerwünschten Quer- oder Ringmoden demjenigen Brechungsindex angepaßt ist, den die Vielfachlaseranordnung (1) an den seitlichen Begrenzungen (2, 3) des laseraktiven Bereichs (12) aufweist.

3. Vielfachlaseranordnung nach Anspruch 1 oder 2, **dadurch gekennzeichnet**, daß das absorbierende Material (4) Halbleitermaterial enthält.

4. Vielfachlaseranordnung nach einem der Ansprüche 1 bis 3, **dadurch gekennzeichnet,** daß das absorbierende Material (4) Germanium enthält.

5. Vielfachlaseranordnung nach einem der Ansprüche 1 bis 4, **dadurch gekennzeichnet,** daß das absorbierende Material (4) Silicium enthält.

6. Vielfachlaseranordnung nach einem der Ansprüche 1 bis 5, **dadurch gekennzeichnet,** daß das absorbierende Material Indiumarsenid (InAs) enthält.

7. Vielfachlaseranordnung nach Anspruch 1, **dadurch gekennzeichnet**, daß das absorbierende Material (4) ein Material enthält, dessen Energiebandabstand kleiner ist als derjenige Energiebandabstand, den das Material der seitlichen Begrenzung (2, 3) des laseraktiven Bereichs (12) aufweist.

8. Vielfachlaseranordnung nach Anspruch 1, **dadurch gekennzeichnet**, daß der Brechungsindex des Kunststoffmaterials an denjenigen Brechungsindex, den das Material der seitlichen Begrenzung (2, 3) der Vielfachlaseranordnung (1) aufweist, zur Auskopplung von unerwünschten Strahlungsmoden angepaßt ist.

## Claims

1. Multiple-laser arrangement (1) comprising phase-coupled laser diodes inside a laser-active region (12) having lateral boundaries (2, 3), characterised by V-shaped trenches as lateral boundaries and either by a material (4) at the lateral boundaries (2, 3) which absorbs unwanted transverse or ring modes in the laser radiation or by deposited plastics material at the lateral boundaries (2,3) which couples out the unwanted transverse or ring modes in the laser radiation.

2. Multiple laser arrangement according to Claim 1, characterised in that, to improve the coupling-in of the unwanted transverse or ring modes, the refractive index of the absorbing material (4) is matched to that refractive index which the multiple laser arrangement (1) has at the lateral boundaries (2, 3) of the laser-active region (12).

3. Multiple laser arrangement according to Claim 1 or 2, characterised in that the absorbing material (4) contains semiconductor material.

4. Multiple laser arrangement according to one of Claims 1 to 3, characterised in that the absorbing material (4) contains germanium.

5. Multiple laser arrangement according to one of Claims 1 to 4, characterised in that the absorbing material (4) contains silicon.

6. Multiple laser arrangement according to one of Claims 1 to 5, characterised in that the absorbing material contains indium arsenide (InAs).

7. Multiple laser arrangement according to Claim 1, characterised in that the absorbing material (4) contains a material whose energy band gap is less than that energy band gap which the material of the lateral boundary (2, 3) of the laser-active region (12) has.

8. Multiple laser arrangement according to Claim 1, characterised in that the refractive index of the plastic material is matched to that refractive index which the material of the lateral boundary (2, 3) of the multiple laser arrangement (1) has in order to couple out unwanted radiation modes.

## Revendications

1. Dispositif à lasers multiples (1) comportant des diodes laser couplées du point de vue de la phase, à l'intérieur d'une zone active pour l'effet laser (12), qui possède des limites latérales (2,3), caractérisé par des sillons en forme de V utilisés comme limites latérales et soit par un matériau absorbant (4), qui absorbe des modes transversaux ou des modes annulaires indésirables du rayonnement laser et est placé au niveau des limites latérales (2, 3), soit par une matière plastique disposée au niveau des limites latérales (2,3) et qui découple les modes transversaux ou les modes annulaires indésirables du rayonnement laser.

2. Dispositif à lasers multiples suivant la revendication 1, caractérisé par le fait que pour une meilleure injection des modes transversaux ou des modes annulaires indésirables, l'indice de réfraction du matériau absorbant (4) est adapté à l'indice de réfraction que possède le dispositif à lasers multiples (1) au niveau des limites latérales (2,3) de la zone active pour l'effet laser (12).

3. Dispositif à lasers multiples suivant la revendication 1 ou 2, caractérisé par le fait que le matériau absorbant (4) contient un matériau semiconducteur.

4. Dispositif à lasers multiples suivant l'une des revendications 1 à 3, caractérisé par le fait que le matériau absorbant (4) contient du germanium.

5. Dispositif à lasers multiples suivant l'une des revendications 1 à 4, caractérisé par le fait que le matériau absorbant (4) contient du silicium.

6. Dispositif à lasers multiples suivant l'une des revendications 1 à 5, caractérisé par le fait que le matériau absorbant contient de l'arseniure d'indium (InAs).

7. Dispositif à lasers multiples suivant la revendication 1, caractérisé par le fait que le matériau absorbant (4) contient un matériau, dont l'écart entre les bandes d'énergie est inférieur à l'écart entre les bandes d'énergie que possède le matériau des limites latérales (2,3) de la zone active pour l'effet laser (12).

8. Dispositif à lasers multiples suivant la revendication 1, caractérisé par le fait que l'indice de réfraction de la matière plastique est adapté à l'indice de réfraction, que possède le matériau de la limite latérale (2,3) du dispositif à lasers multiples (1), pour le découplage de modes de rayonnement indésirables.
